# EUROPEAN PATENT APPLICATION

(11) **EP 2 077 585 A1**
(43) Date of publication of application: **08.07.2009**
(21) Application number: 07828791.9
(22) Date of filing: 28.09.2007
(51) Int. Cl.: H01L 31/04

(54) **SOLAR BATTERY ELEMENT AND METHOD FOR MANUFACTURING THE SAME**

(30) Priority: 28.09.2006 JP 2006264009; 27.10.2006 JP 2006292394; 30.05.2007 JP 2007144025
(71) Applicant: Kyocera Corporation, Kyoto-shi Kyoto 612-8501 (JP)
(72) Inventor: KOBAMOTO, Naoya, Higashiomi-shi Shiga 5278555 (JP); SAKAMOTO, Tomonari, Higashiomi-shi Shiga 5278555 (JP); HOSOMI, Kazunori, Higashiomi-shi Shiga 5278555 (JP)
(74) Representative: Keck, Stephan
(86) International application number: PCT/JP2007/069050
(87) International publication number: WO 2008/047580

(57) **Abstract**

[Object] An object is to provide a solar cell element exhibiting a reduced warp, a low resistance loss and a high adhesion between the silicon substrate and the electrode, and a method for manufacturing the same.

[Solving Means] The solar cell element includes a silicon substrate 1, and a first electrode 5a formed of aluminum and a metal containing zinc on the silicon substrate 1. The solar cell element is produced by a method including the step of preparing a silicon substrate and an electroconductive paste containing an aluminum powder and a powder containing zinc, the step of applying the electroconductive paste onto the silicon substrate, the step of heating the electroconductive paste applied onto the silicon substrate at a temperature higher than the melting point of the powder containing zinc to melt the electroconductive paste, and the step of cooling the molten electroconductive paste to form an electrode.

## Description

### Technical Field

The present invention relates to a solar cell element and a method for manufacturing the same.

### Background Art

Solar cell elements convert solar energy into electrical energy.

A known solar cell element includes a silicon substrate having a light-reception surface and a back surface and electrodes mainly containing aluminum formed on the surface of the silicon substrate.

The thickness of the silicon substrate used for the solar cell element has been being reduced. As the thickness of the silicon substrate is reduced, the silicon substrate becomes liable to warp due to the difference in thermal expansion from the aluminum electrode.
Patent Document 1: Japanese Unexamined Patent Application Publication No. 2003-223813

### Disclosure of Invention

### Problems to be Solved by the Invention

The solar cell element is expected to spread more widely, and it is accordingly important for the solar cell element to exhibit high conversion efficiency. In order to increase the conversion efficiency, it is important to reduce the warp of the silicon substrate and to increase the adhesion between the silicon substrate and the electrode.

Accordingly, an object of the invention is to provide a high-performance solar cell element.

### Means for Solving the Problems

A solar cell element of the invention includes a silicon substrate, and a first electrode formed of aluminum and a metal containing zinc on the silicon substrate.

### Advantages

The solar cell element of the invention includes an electrode formed on aluminum and a metal containing zinc on a silicon substrate. In this solar cell element, the warp of the silicon substrate resulting from the difference in thermal expansion coefficient between the silicon substrate and aluminum can be alleviated to prevent the reduction of the adhesion between the electrode and the silicon substrate.

### Prefered Embodiments for Carrying Out the Invention

Embodiments of the solar cell element and the method for manufacturing the same according to the invention will now be described with reference to the drawings.

### <solar cell element>

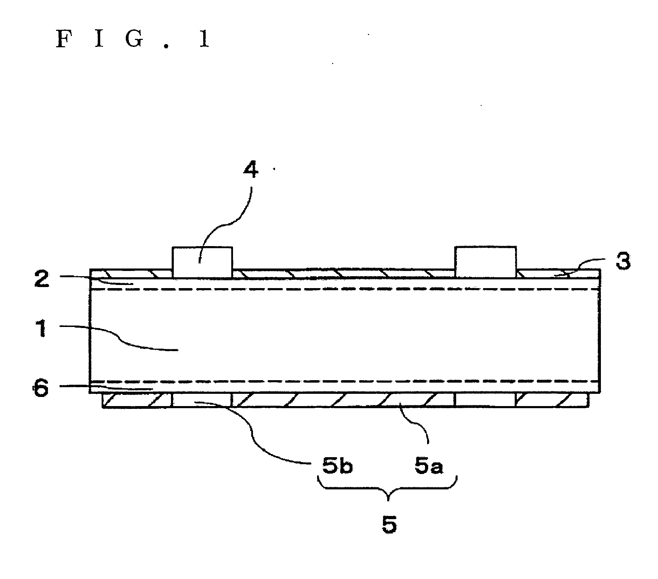

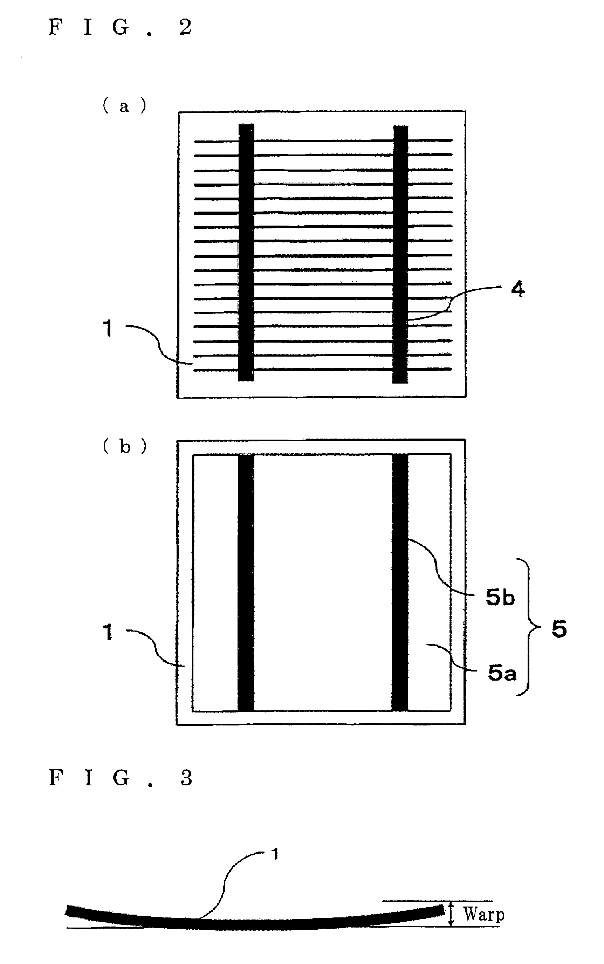

Fig. 1 is a sectional view of a solar cell element according to an embodiment. Fig. 2(a) is a plan view of a first surface (light-reception surface) of the solar cell element shown in Fig. 1, and Fig. 2(b) is a plan view of a second surface (opposite to the light-reception surface) of the solar cell element shown in Fig. 1.

The solar cell element of the present embodiment includes a silicon substrate 1 having a first surface (light-reception surface) and a second surface (back surface), and a first electrode formed of aluminum and a metal containing zinc on the silicon substrate 1. In Fig. 1, the first electrode is disposed on the second surface of the silicon substrate 1. This structure can alleviate the warp of the silicon substrate 1 even if the silicon substrate 1 has a small thickness of, for example, 200 µm or less.

In the solar cell element shown in Fig. 1, the silicon substrate 1 having a first conductivity type has a front surface electrode 4 and a back surface electrode 5. The back surface electrode 5 includes current-collector portions (first electrodes) 5a and power-extracting portions (second electrodes) 5b through which the electricity collected through the current-collector portion 5a is extracted. The first surface of the silicon substrate 1 has a diffusion layer 2 having a second conductivity type and an antireflection coating 3. The second surface of the silicon substrate 1 has a back surface electric field region 6.

The operation of the solar cell element shown in Fig. 1 will now be simply described.

When light enters the solar cell element from the light-reception surface side, the light is mainly absorbed by the bulk region of the silicon substrate 1, which is a p-type semiconductor, and converted into electricity to produce electron-hole pairs (electron carriers and hole carriers). The electron carriers and hole carriers act as the photo-excitation source (photo-production carriers) and generate a photoelectromotive force in the solar cell element.

The antireflection coating 3 reduces the reflectance of the light in a desired wavelength region depending on the refractive index and the thickness of the film defining the antireflection coating, and thus increases the amount of photo-production carriers to increase the photocurrent density Jsc of the solar cell element.

In the solar cell element of the present invention, having the above-described structure as shown in Fig. 1, the silicon substrate 1 has current-collector portions 5a (first electrodes) being fired electrodes mainly made of aluminum. The current-collector portions 5a also contain externally added inorganic particles having a lower melting point than aluminum. The inorganic particles are made of a metal containing zinc.

The current-collector portion 5a mainly made of aluminum mentioned herein means that the current-collector portion 5a contains a higher weight of aluminum than that of the inorganic particles. The current-collector portion 5a containing externally added inorganic particles means that an electroconductive paste being the electrode material contains the inorganic particles.

In the solar cell element, the warp of the solar cell element resulting from the difference in thermal expansion coefficient between the silicon substrate 1 and the current-collector portion 5a can be reduced, and besides the adhesion between the current-collector portion 5a and the silicon substrate 1 can be prevented from decreasing.

In addition, when the inorganic particles are zinc or a zinc alloy, the resistance loss of the current-collector portions 5a can be reduced more than that of the known electrode made of aluminum paste containing SiO₂, Al₂O₃ or the like. Thus, the decrease in FF value (fill factor) can be prevented, and accordingly the reduction of the output power can be prevented. This is probably because the deterioration of power-extracting portions 5b and the current-collector portions 5a at their contacts is reduced and, accordingly, the decrease in FF value is prevented. Consequently, a solar cell element can be provided in which the reduction of the element efficiency is prevented more than in use of the known electrode. The inorganic particles containing zinc used in the embodiment do not contain glass components, such as zinc oxide.

As shown in Figs. 2(a) and 2(b), the current-collector portions 5a are formed over substantially the entire main surface of the silicon substrate except the regions of the power-extracting portions 5b. Thus, aluminum, which is a p-type dopant element, is sufficiently diffused in the back surface of the silicon substrate 1 to form a back surface electric field region 6 (BSF region) over substantially the entire back surface of the solar cell element. Consequently, the open-circuit voltage Voc can be increased by the BSF effect, and the element efficiency can be increased accordingly.

If the current-collector portions 5a further contain a glass frit, the adhesion between the silicon substrate 1 and the current-collector portions 5a can further be enhanced. Consequently, the reduction in output power, which is caused by separation of the current-collector portions 5a from the silicon substrate 1, can further be prevented.

Preferably, the current-collector portion 5a contains 3 to 50 parts by weight of zinc or zinc alloy relative to 100 parts by weight of aluminum. Thus, the warp of the silicon substrate 1 can sufficiently be reduced in addition to the above-described advantage. Consequently, the values of the adhesion, the electroconductivity, and the output power can simultaneously be favorable to form a more sufficient back surface electric field region 6 (BSF region).

Furthermore, if the purity of zinc or zinc alloy is 97% or more, the warp of the silicon substrate can be reduced without affecting the performance.

In order to examine whether or not the electrode contains zinc or zinc alloy, zinc element can be measured by EPMA, for example.

### <Method for manufacturing the solar cell element>

A method for manufacturing the solar cell element will now be described.

The silicon substrate 1 used in the embodiment is made of, for example, monocrystalline silicon or polycrystalline silicon containing a semiconductor dopant, such as boron (B). The silicon substrate 1 made of polycrystalline silicon can be mass-produced. Such a silicon substrate 1 is produced by cutting an ingot produced by a crystal pulling method or casting into pieces of about 10 cm x 10 cm to 25 cm x 25 cm and slicing the pieces to a thickness of 500 µm or less, preferably 250 µm or less. The cut surface of the silicon substrate 1 is very slightly etched to clean with NaOH or KOH, or hydrofluoric acid or fluoronitric acid.

Subsequently, a uneven (rough surface) structure is formed in the surface of the silicon substrate 1 through which sunlight enters. If the light-reception surface of the silicon substrate 1 is rough and has asperities, sunlight is prevented from reflecting from the light-reception surface of the silicon substrate 1.

For the next step, a diffusion layer 2 having a second conductivity type is formed in the light-reception surface of the silicon substrate 1 to form a pn junction between the diffusion layer and the bulk region of the silicon substrate. When the first conductivity type is the p type, the diffusion layer 2 acts as an n-type layer 2. A Group V element is used as the n-doping element, such as phosphorus (P), and an n+ type layer having a sheet resistance of about 30 to 300 ohms per square is formed. When the first conductivity type is the n type, the diffusion layer 2 acts as a p-type layer 2. A Group III element is used as the p-doping element, such as boron (B). The expression P+ or n+ means that the dopant content is high.

The diffusion layer 2 is formed, for example, by a thermal diffusion coating in which the surface of the silicon substrate 1 is coated with a P₂O₅ paste, by gas phase thermal diffusion using POCl₃ (phosphoryl chloride) gas as a diffusion source, or by ion implantation in which p+ ions are directly diffused. The diffusion layer 2 has a depth of about 0.2 to 0.5 µm. If a diffusion region is formed in the surface opposite the intended surface, the area for the diffusion region may be coated with an anti-diffusion film in advance and etched later. For example, the diffusion layer except the diffusion layer 2 formed in the front surface of the silicon substrate 1 can be removed by etching with hydrofluoric acid or a mixture of hydrofluoric acid and nitric acid with the front surface of the silicon substrate 1 coated with a resist film and then the resist is removed.

However, the formation of the diffusion layer 2 is not limited to the above-described method. For example, a hydrogenated amorphous silicon layer or a crystalline silicon layer including a microcrystalline silicon layer may be formed by a process and under conditions for forming thin films. In addition, an i-type silicon region may be formed between the silicon substrate 1 and the diffusion layer 2.

Subsequently, the surface of the diffusion layer 2 of the silicon substrate 1 is coated with an antireflection coating 3. The material of the antireflection coating 3 may be a SiNx film (having a range of compositions around the Si₃N₄ stoichiometric composition), a TiO₂ film, a SiO₂ film, a MgO film, an ITO film, a SnO₂ film, a ZnO film and so on. If the antireflection coating 3 formed over the silicon substrate 1 has a refractive index of about 1.8 to 2.3 and a thickness of about 500 to 1200 Å, light reflection can be reduced effectively. Such an antireflection coating 3 may be formed by PECVD, vapor deposition, sputtering or the like. If the front surface electrodes 4 are not formed by a fire-through method described below, the antireflection coating 3 is formed into a predetermined pattern for forming the front surface electrodes 4. The patterning may be performed by etching using, for example, a resist mask (wet etching or dry etching), or by forming a mask in advance of the formation of the antireflection coating 3 and removing the mask after the completion of the antireflection coating 3. If a so-called fire-through method is applied, patterning is not necessary. In the fire-through method, the front surface electrodes 4 and the diffusion layer 2 are brought into electrical contact with each other by applying an electrode paste for the front surface electrodes 4 onto the antireflection coating 3 and then firing the paste. Since the fire-through method is applied to the structure shown in Fig. 2(a), patterning is not performed.

A back surface electric field region (BSF region) 6 is formed in the back surface of the silicon substrate 1. The BSF region contains a dopant in a higher concentration than the silicon substrate 1. When the first conductivity type is the p type, boron or aluminum is used as the dopant element to form a p+ type region. Consequently, the carrier recombination loss can be reduced in the vicinity of the back surface of the silicon substrate 1. Photo-production carriers generated in the vicinity of the back surface of the silicon substrate 1 are accelerated by the electric field, and consequently electric power is extracted effectively and the photosensitivity particularly to long wavelength light is enhanced. Accordingly, the photocurrent density Jsc is increased, and the minority carrier (electron) density is reduced in the back surface electric field region 6 (BSF region). Thus, the amount of diode current (dark current) is reduced in the region in contact with the back surface electrode 5, and the open-circuit voltage Voc is increased.

Such a back surface electric field region 6 can be formed by diffusing a first conductivity type dopant at a high concentration into the silicon substrate 1. First, for example, a diffusion barrier is formed of, for example, an oxide layer over the diffusion layer 2 in advance. Then, the back surface electric field region 6 is formed by thermal diffusion using BBr₃ (boron tribromide) as the diffusion source at a temperature of about 800 to 1100°C. In particular, when aluminum is used, an electroconductive paste containing aluminum powder and an organic vehicle is applied by printing and then heat-treating (firing) the paste at a temperature of about 700 to 850°C. The aluminum is thus diffused into the silicon substrate 1 to form the back surface electric field region 6. The process of printing the electroconductive paste, followed by firing can form a desired diffusion region in a printed surface, and, in addition, does not require the removal of the diffusion layer formed in the back surface simultaneously with the formation of the diffusion layer 2 as described above and having the opposite conductivity type, or the n type.

For the next step, the front surface electrodes 4 and the back surface electrode 5 including the current-collector portions 5a (first electrode) and the power-extracting portions 5b (second electrode) are formed on the surfaces of the silicon substrate 1, as below. In the present embodiment, the back surface electrode 5 is in ohmic contact with the BSF layer 4.

For forming the front surface electrodes 4, a silver paste prepared by adding 10 to 30 parts by weight of organic vehicle and 0.1 to 5 parts by weight of glass frit to 100 parts by weight of metal powder containing silver or the like is applied to form a predetermined electrode shape, such as a grid shape, as shown in Fig. 2(a), and fired at the maximum temperature of 600 to 850°C for several tens of seconds to several tens of minutes, thereby forming the electrodes. The paste can be applied by screen printing. After the application, preferably, the solvent is vaporized at a predetermined temperature to dry.

For the current-collector portions 5a, an electroconductive paste containing a metal material containing zinc, aluminum and an organic vehicle is applied over substantially the entire surface of the back surface except the regions in which the power-extracting portions 5b are to be formed, as shown in Fig. 2(b). The paste can be applied by screen printing. After the application, preferably, the solvent is vaporized at a predetermined temperature to dry.

For the power-extracting portions 5b, an electroconductive paste prepared by adding 10 to 30 parts by weight of organic vehicle and 0.1 to 5 parts by weight of glass frit to 100 parts by weight of metal powder containing silver powder or the like is applied to form the electrode shape shown in Fig. 2(b), in the same manner as the formation of the front surface electrodes 4. In this instance, the silver paste is applied to positions at which the silver paste partially comes into contact with the electroconductive paste so as to overlap and intersect the current-collector portion 5a and the power-extracting portions 5b. The silver paste can be applied by screen printing or other known methods. After the application, preferably, the solvent is vaporized at a predetermined temperature to dry.

The organic vehicle can be prepared by dissolving at least one resin selected from the group including cellulose resins, such as methyl cellulose, ethyl cellulose and nitro cellulose, acrylic resins, such as methyl methacrylate, and butyral resins in an organic solvent, such as butyl carbitol, butyl carbitol acetate, butyl cellosolve, butyl cellosolve acetate, terpineol, hydrogenated terpineol, hydrogenated terpineol acetate, methyl ethyl ketone, isobonyl acetate, or nopyl acetate.

The glass frit is preferably glass containing PbO₂, B₂O₃, SiO₂, ZnO or the like from the viewpoint of enhancing the adhesion between the electrode and the silicon substrate 1. The glass frit can be added in an amount of about 0.1 to 5 parts by weight relative to 100 parts by weight of aluminum. Preferred glass frit content is 1.5 parts by weight or less because a higher glass frit content tends to increase the warp.

After the application of the electroconductive paste and the silver paste onto the silicon substrate 1, the pastes are dried in a drying oven, and then fired at a maximum temperature of 700 to 850°C for several tens of seconds to several tens of minutes in a firing oven, thereby forming the back surface electrode 5 (current-collector portions 5a and power-extracting portions 5b).

The method for forming such a back surface electrode will now be described in detail.

The electroconductive paste used in the present invention contains an inorganic material and aluminum. The inorganic material is a metal material having a melting point lower than aluminum and containing zinc. "Containing zinc" mentioned herein means that the metal material is constituted of zinc or a zinc alloy. For example, aluminum has a melting point of 660.4°C, and zinc used as the inorganic material has a melting point of 419.6°C.

When the inorganic material is constituted of zinc or a zinc alloy, the particles of the inorganic material can have such a size as can pass through, for example, a 75 µm mesh screen. The mean particle size is preferably 30 µm or less, and more preferably 15 µm or less. The aluminum and inorganic material contained in the electroconductive paste may be powder in a form of spheres, flakes or formless shapes. Such aluminum can be powder having a mean particle size of, for example, about 3 to 20 µm, and 10 to 30 parts by weight of organic vehicle can be added to 100 parts by weight of aluminum. The paste may contain a glass frit in a proportion of 0.1 to 5 parts by weight to 100 parts by weight of aluminum.

The method for manufacturing the solar cell element includes the first step of applying the electroconductive paste onto the silicon substrate 1. The application can be performed by various methods including screen printing, a roll coater method and dispenser method.

After that, the second step is performed of firing the electroconductive paste at a temperature higher than the melting point of the inorganic material. More specifically, the paste is fired at a maximum temperature of 700 to 850°C for several tens of seconds to several tens minutes in a firing oven, thus forming the current-collector portions 5a. The zinc-containing metal material in the electroconductive paste is brought into a state of liquid phase by firing at a temperature higher than its melting point in the second step. Therefore the zinc-containing metal material keeps liquid phase at temperatures between its melting point and the maximum firing temperature. Probably, the metal material containing zinc in a liquid phase flows (spread) so as to compensate for the reduction in volume of aluminum during cooling from the maximum firing temperature to the melting point of the zinc-containing metal material, and thus alleviates the reduction in total volume of the paste that can be caused by cooling. At this time, the particles of the aluminum powder are joined to each other with the inorganic material. Thus, the warp of the silicon substrate can be alleviated which results from the difference in thermal expansion coefficient between the silicon substrate and the aluminum.

Preferably, rapid heating and rapid cooling are performed from the viewpoint of increasing the output power of the solar cell. For example, heating and cooling are performed at a rate of 20°C/s or more, and the retention time of the peak temperature is several seconds. If rapid cooling is performed at a rate of 30°C/s or more, the warp of the silicon substrate can be increased after firing. However, the present invention can sufficiently reduce the warp even if rapid cooling is performed. The rates of heating and cooling can be calculated from the gradient of the profile (temperature-time) of temperatures before and after reaching a peak temperature, measured with a thermocouple attached to the silicon substrate 1.

In comparison between the electroconductive paste and an aluminium paste containing SiO₂, Al₂O₃ or the like, the electrode made of the zinc-containing metal and aluminium after the second step can prevent the reduction of the adhesion between the current-collector portions 5a and the silicon substrate 1.

Preferably, the electroconductive paste contains 3 to 50 parts by weight of at least one of zinc powder and a zinc alloy powder relative to 100 parts by weight of aluminum powder. If the zinc or zinc alloy content is 3 parts by weight or more, the above-described effects can be produced more favorably.

The firing oven used in the above-described method will now be described.

The firing oven includes a furnace body 21 having an internal space, a transport mechanism 25 transporting a work placed thereon to be heated from a transport entrance 23 to a transport exit 24 in the furnace body, and heating means (for example, infrared ray lamp) 27 disposed to an upper side of the transport mechanism 25 for heating the work. Preferably, an exhaust unit 28 is provided at the ceiling of the furnace body 21 for discharging the solvent vaporized from the heated work to the outside of the furnace body 21 and additional heating means 27 are further provided in the firing oven for heating the ceiling of the furnace body 21 and the exhaust unit 28.

The furnace body 21 has a double structure made of a heat-resistant and corrosion-resistant metal, such as stainless steel, and a heat insulator is disposed in the gap in the double structure.

The furnace body 21 has openings for the transport entrance 23 and transport exit 24 through which the belt of the transport mechanism 25 transports the work 22 thereon between the internal space of the furnace body 21 and the external space. The belt is turned around by a rotating roller at the position from which the belt protrudes to the outside of the furnace body. In addition, a sensor or a buzzer including, for example, a photo interpreter or a proximity sensor may be disposed to indicate whether the work 22 comes in or out, in the vicinity of the transport entrance 23 and the transport exit 24.

The transport mechanism 25 includes a mesh belt or a zonal belt made of, for example, an alloy composition, such as stainless steel alloy, Ni-Cr alloy or an alloy of manganese, molybdenum, titanium, aluminum, niobium, chromium, zirconium or boron, a rotating roller 31 for turning around the belt at both ends in the running direction of the belt, a driving roller 32 for transmitting a driving force for transport to the belt, a servomotor (not shown) for generating the driving force, and a connection chain (not shown) for connecting the driving roller 32 and the servomotor. Both ends of the belt are connected to form a ring so as to round endlessly in the transporting direction. An angular velocity sensor, such as of a rotary encoder, is provided to the servomotor, the driving roller 32 and/or the rotating roller 31 to detect the angular velocity of the shaft, and further the transporting speed, one after another. The servomotor and/or the angular velocity sensor is electrically connected to an arithmetic processing unit with a signal line not shown in the figure so as to sequentially detect the transporting speed according to the input signal from the arithmetic processing unit and/or the output to the arithmetic processing unit and controls the transporting speed to a predetermined speed.

The infrared ray lamp 27 being a heating means is electrically connected to a power source disposed outside the furnace body 21 with a power cable (not shown), and receives an alternating current power or a direct current powder applied from the power source, thereby being heated to emit infrared rays, such as far infrared rays or near infrared rays. At least one infrared ray lamp is arranged, for example, in a line, an array, or an arch manner inside the furnace body.

The infrared ray lamp 27 includes a heating/light-emitting member generating heat or emitting light by energization, made of, for example, carbon, molybdenum, tungsten or Ni-Cr, and that is enclosed in an evacuated envelope. Alternatively, an infrared light bulb may be used which has a reflection plate or the like reflecting infrared rays irradiating the rear of the heating/light-emitting member to the front side. An infrared heater may also be used which includes a ceramic sintered compact of silicon carbide, alumina, cordierite or the like in which a heating/light-emitting member is embedded and whose front surface layer is coated with, for example, a ceramic coating for increasing the radiation efficiency of infrared rays. The infrared ray lamp 27 has a thermocouple made of, for example, alumel, chromel, platinum or rhodium, or a lamp temperature sensor being a platinum resistor element on the surface or inside thereof. The temperature sensor measures its own temperatures and surroundings. According to the measured temperature, the voltage applied to the infrared ray lamp 27 is controlled by a driver circuit or an inverter circuit so that the work 22 can be heated and dried at a predetermined temperature. The circuit controlling the applied voltage includes a thyristor, a power transistor and a power FET (field-effect transistor).

The exhaust unit 28 includes an exhaust duct provided at the ceiling of the furnace body 21 and closely communicating with the internal space of the partially open furnace body 21, and a negative pressure generator (not shown) including a blower motor and a venturi tube. The negative pressure generator creates a relatively negative pressure in the exhaust duct and in the upper space in the furnace body, and thus the exhaust unit 28 discharges the vapor produced in the internal space of the furnace body 21.

A hot air supply unit 29 includes a filter device for removing gaseous impurities in air taken from the outside of the furnace body 21 and nitrogen gas, dust and the like, a flow meter and a pressure gauge for measuring the flow rate or pressure of the gas that has passed through the filter device, a heater for heating the gas that has passed through the filter device to a predetermined temperature, a temperature sensor and a pressure gauge for measuring the temperature or pressure of the gas that has passed through the heater, a blower for delivering the gas that has passed through the heater to the inside of the furnace body through a hot air pipe, and the hot air pipe through which the hot air from the blower is introduced to a predetermined position inside the furnace body.

The hot air pipe 30 has at least one hole at a predetermined position inside the furnace body 21. An ejection nozzle is secured to the hole, and ejects hot air to heat the ceiling of the furnace body 21 and the vicinity of the duct of the exhaust unit 28. Desirably, the ejection nozzle contains an ejection direction/shape controlling mechanism so as to finely control the ejection direction and ejection shape. The ejection nozzle may have a temperature sensor for measuring the temperature of the ejected hot air, or an ejection detecting sensor for detecting whether or not hot air is ejected so as to prevent the failure of hot air ejection resulting from the clogging of the ejection nozzle. Preferably, the hot air pipe 30 is disposed above the infrared ray lamp 27. Thus, the hot air pipe 30 does not interfere with the irradiation of the work 22 with infrared rays emitted from the infrared ray lamp 27 because the infrared ray lamp faces downward toward the work 22 on the transport unit.

The firing oven used in the present embodiment includes a furnace body 21 having an internal space and a transport mechanism 25 transporting a work 22 to be heated placed thereon from a transport entrance 23 to a transport exit 24 in the furnace body. In addition, an infrared ray lamp 27 being a heating means opposes the position in the furnace body 21 where the work 22 is placed and transported. By energizing the infrared ray lamp 27, the lamp 27 heats the work 22. Thus, the work 22 placed on the transport mechanism 25 is transported from the transport entrance 23 to the transport exit 24, and irradiated with infrared rays emitted from the infrared ray lamp 27 disposed inside the furnace body 21, thereby being heated. Consequently, the solvent, such as organic solvent or water, and the organic vehicle contained in the work 22 are vaporized, and the work 22 is thus fired.

The vaporized solvent and the vapor of the organic vehicle produced by the radiation from the infrared ray lamp 27 flow toward the exhaust unit 28 and are discharged from the inside of the furnace body 21. At this time, the ceiling and the vicinity of the exhaust unit of the furnace body 21 are heated by being exposed to hot air ejected from the hot air pipe of the hot air supply unit. Consequently, the vapor of the solvent is discharged from the inside of the furnace body 21 without reaching the dew point. Therefore, the solvent does not drip onto the work 22 to contaminate the work 22.

Preferably, the temperature of the hot air from the hot air pipe 30, at the position where the hot air is ejected from the hot air pipe, is in the range of the dew point of the solvent or more, and less than the flash point of the solvent or the organic vehicle if the solvent or the organic vehicle is flammable. Such hot air temperature is for example about 50 to 350°C. Preferably, the total ejection amount of the hot air is about 10% to 300% of the amount of the exhaust from the exhaust unit. Preferably, the ejection speed of the hot air ejected from the ejection nozzle is such that the hot air can reach the ceiling of the furnace body and the vicinity of the exhaust duct and sufficiently heat the ceiling and the vicinity of the exhaust duct. Such ejection speed is for example about 0.1 to 100 m/s. The hot air ejected from the ejection nozzle preferably has a shape of, for example, triangular pyramid, fan or the like in the longitudinal section, and a shape of circle, oval or rectangle in the cross section. Preferably, the ejection nozzle is disposed at a position where hot air can reach the ceiling of the furnace body and the vicinity of the exhaust duct and sufficiently heat the ceiling and the vicinity of the exhaust duct. The distance from the ejection nozzle to the ceiling of the furnace body and the vicinity of the exhaust duct is, for example, about 10 to 300 mm. The amount of exhaust in terms of volume per unit time is about 1 to 1000 times of the volume per unit time of the solvent vapor in the furnace at the temperature and the pressure in the furnace, and is specifically, for example, about 1 to 1000 liters per minute.

In this structure and arrangement, the ceiling of the furnace body and the vicinity of the exhaust duct are exposed to hot air ejected from the hot air pipe of the hot air supply unit and thus heated. The vapor of the solvent thus can be discharged from the inside of the furnace body without reaching the dew point, and accordingly the solvent does not drip onto the work 22 to contaminate the work 22.

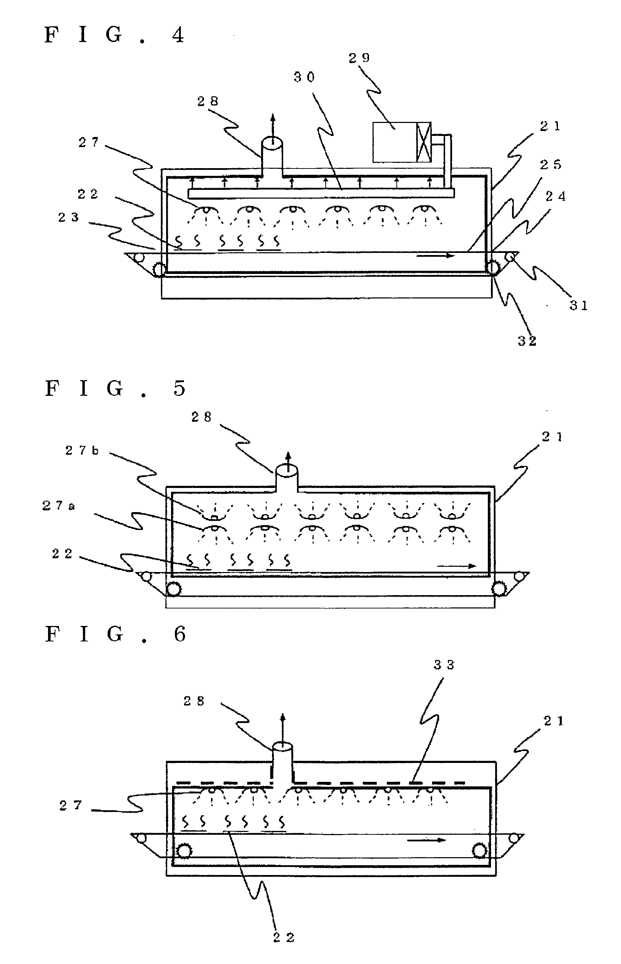

Fig. 5 is a cross-sectional view of a firing oven according to another embodiment of the invention.

The infrared ray lamp shown in this figure includes a first infrared ray lamp 27a heating the work and a second infrared ray lamp 27b heating the furnace body. The first infrared ray lamp 27a is disposed at a lower level and the second infrared ray lamp 27b is disposed at a higher level, with their backs opposing each other. In this arrangement, the infrared rays emitted from the first infrared ray lamp 27a are not hindered from reaching the work 22, and the infrared rays emitted from the second infrared ray lamp 27b are not hindered from reaching the ceiling of the furnace body 21.

Thus, the ceiling of the furnace body 21 and the vicinity of the exhaust duct are heated by being exposed to the infrared rays from the second infrared ray lamp 27b, and accordingly, the vapors of the solvent and the organic vehicle can be discharged from the inside of the furnace body 21 without reaching their dew points. Therefore, the solvent does not drip onto the work 22 to contaminate the work 22.

Fig. 6 is a cross-sectional view of another firing oven according to the invention.

A heater 33 for heating the furnace body may be a sheet-like electrothermal heater, a wire-wound electrothermal heater or an electromagnetic induction heater. The electromagnetic induction heater applies an alternating current to a coil disposed close to the wall of the furnace body 2 to generate an eddy current at the surface of the wall of the furnace body, which is made of an electromagnetic material, or in an electromagnetic material in contact with the wall of the furnace body, thereby generating Joule heat. The heater 33 for heating the furnace body may be, for example, a heat source including a fluid tube embedded therein through which a heated fluid flows to perform heat exchange or the like, and is embedded in or disposed in contact with the wall of the furnace body 21 or the exhaust duct of the exhaust unit 28.

Thus, the vaporized solvent and the vapor of the organic vehicle produced by the radiation from the infrared ray lamp 27 flow toward the exhaust unit 28 and are discharged from the inside of the furnace body 21. In addition, since the ceiling of the furnace body 21 and the vicinity of the exhaust duct of the exhaust unit 28 are directly and/or indirectly heated by the heater 33 for heating the furnace body embedded in or disposed in contact with the wall of the furnace body 21 and/or the wall of the exhaust duct, the vapors of the solvent and the organic vehicle can be discharged from the inside of the furnace body 21 without reaching their dew points. Therefore, the solvent does not drip onto the work 22 to contaminate the work 22.

The above-described firing oven can be used as a drying oven after the electroconductive paste is applied, and may be used for drying or firing not only the silver paste, but also aluminum paste.

Other heating devices may be used as the heating means for heating the work instead of the infrared ray lamp. Such heating device can produce the same effect.

The invention is not limited to the above-describe embodiments, and various modifications may be made without departing from the scope of the invention. For example, the structure of the solar cell element is not limited to the above-described structure, and may be applied to a solar cell element having a fired electrode on only one surface, or is not limited to crystalline silicon solar cell elements.

For forming the current-collector portions 5a by applying and firing the electroconductive paste and forming the power-extracting electrodes 5b by applying and firing the silver paste, the firing steps may be performed separately.

After the current-collector portions 5a are formed by applying the electroconductive paste, the silver paste may be applied to form the power-extracting portions 5b, and vice versa. Such processes can produce the effect of the invention.

The drying step of the applied electroconductive paste may be omitted if the electroconductive paste does not soil the workbench or the screen of the printer when the electroconductive paste is subsequently applied.

The zinc alloy is not limited to zinc-aluminum alloy used in the following Examples.

### EXAMPLE 1

An n-type diffusion layer 2 having a sheet resistance of 70 ohms per square was formed by diffusing phosphorus atoms into a front surface of a p-type silicon substrate 1 of polycrystalline silicon having a thickness of 150 µm and an outer dimensions of 15 cm x 15 cm. Then, a silicon nitride antireflection coating 3 was formed on the diffusion layer 2. After 1600 mg of electroconductive paste was applied in an area of 14.5 cm x 14.5 cm on the back surface, the electroconductive pates was fired at an maximum temperature of 790°C and a cooling rate of 30°C/s, and further a silver paste was applied onto the front surface and the back surface and then fired to complete a solar cell element.

The current-collector portions 5a of Samples 1 to 10 were formed with a paste containing 100 parts by weight of aluminum powder, 20 parts by weight of organic vehicle, 0.5 part by weight of glass frit, and 1 to 60 parts by weight of zinc powder.

The current-collector portions 5a of Samples 11 to 20 were formed with a paste containing 100 parts by weight of aluminum powder, 20 parts by weight of organic vehicle, 0.5 part by weight of glass frit, and 1 to 60 parts by weight of zinc-aluminum alloy powder.

The current-collector portions 5a of Samples 21 to 24 were formed with a paste containing 100 parts by weight of aluminum powder, 20 parts by weight of organic vehicle, 0.5 part by weight of glass frit, and 3 to 15 parts by weight of tin powder. Tin has a melting point of 231.97°C.

For comparative examples, the current-collector portions of Samples 25 to 28 were formed with a paste containing 100 parts by weight of aluminum powder, 20 parts by weight of organic vehicle, 0.5 part by weight of glass frit, and 3 to 15 parts by weight of SiO₂ powder. The current-collector portions of Sample 29 was formed with a paste containing 100 parts by weight of aluminum powder, 20 parts by weight of organic vehicle, and 0.5 part by weight of glass frit.

Thus prepared solar cell elements were evaluated for the warp, the output power, and the adhesion between the current-collector portions 5a and the silicon substrate 1. Fig. 3 is a representation showing the evaluation method for the warps of the solar cell elements of the example. In the present embodiment, the warp including the thickness of the silicon substrate 1 was evaluated. More specifically, the warp was evaluated as the difference in height of the substrate lying on a horizontal plane between the highest point and the lowest point (level), as shown in Fig. 3. The evaluation results are shown in Table 1. The output power was measured with a solar simulator under the conditions AM 1.5. The adhesion of the current-collector portions 5a was evaluated by a peeling test using an adhesive tape. A heat-resistant masking tape 2142 manufactured by Sumitomo 3M was used as the adhesive tape. Current-collector portions peeled seriously, whose adhesion is insufficient, were determined to be not acceptable. In Table 1, samples that did not adhere to the adhesive tape were determined to be good; samples that adhered to less than one-fifth of the adhesive surface of the tape were determined to be fair; and samples that adhered to one-fifth of the adhesive surface of tape or more were determined to be poor.

**[Table 1]**

| Number | Additive | | Warp | Output power | Adhesion |
|---|---|---|---|---|---|
| | Species | Part(s) by weight | (mm) | (W) | (-) |
| 1 | Zn | 1 | 4.48 | 3.707 | Good |
| 2 | Zn | 3 | 4.34 | 3.704 | Good |
| 3 | Zn | 7.5 | 4.28 | 3.700 | Good |
| 4 | Zn | 10 | 4.16 | 3.702 | Good |
| 5 | Zn | 15 | 4.07 | 3.662 | Good |
| 6 | Zn | 20 | 3.97 | 3.679 | Good |
| 7 | Zn | 30 | 3.78 | 3.663 | Good |
| 8 | Zn | 40 | 3.74 | 3.645 | Good |
| 9 | Zn | 50 | 3.71 | 3.648 | Good |
| 10 | Zn | 60 | 3.69 | 3.611 | Fair |
| 11 | ZnAl | 1 | 4.49 | 3.710 | Good |
| 12 | ZnAl | 3 | 4.36 | 3.708 | Good |
| 13 | ZnAl | 7.5 | 4.30 | 3.707 | Good |
| 14 | ZnAl | 10 | 4.16 | 3.703 | Good |
| 15 | ZnAl | 15 | 4.08 | 3.700 | Good |
| 16 | ZnAl | 20 | 4.02 | 3.689 | Good |
| 17 | ZnAl | 30 | 3.82 | 3.672 | Good |
| 18 | ZnAl | 40 | 3.78 | 3.666 | Good |
| 19 | ZnAl | 50 | 3.77 | 3.652 | Good |
| 20 | ZnAl | 60 | 3.74 | 3.620 | Fair |
| 21 | Sn | 3 | 4.32 | 3.661 | Good |
| 22 | Sn | 7.5 | 4.26 | 3.594 | Good |
| 23 | Sn | 10 | 4.10 | 3.489 | Good |
| 24 | Sn | 15 | 3.98 | 3.420 | Good |
| 25 | SiO2 | 3 | 4.44 | 3.692 | Good |
| 26 | Si02 | 7.5 | 4.36 | 3.656 | Fair |
| 27 | SiO2 | 10 | 4.32 | 3.584 | Fair |
| 28 | Si02 | 15 | 4.21 | 3.422 | Poor |
| 29 | none | 0 | 4.66 | 3.701 | Good |

Table 1 shows that while the warp of Sample 29, which is a comparative example, was 4.66 mm, the warps of Samples 1 to 24, which are examples of the invention, were 4.49 mm or less.

In Samples 25 to 28, which are comparative examples, the warp was reduced by increase of the SiO₂ content, but the adhesion was reduced. On the other hand, Samples 1 to 24 did not exhibit reduced adhesion.

In addition, Samples 1 to 20 reduced the warp more than Sample 29 and kept the adhesion and output power equal to Sample 29.

According to the present example, the warp was reduced by 0.3 mm or more from the warp of the Sample 29 being an comparative example, by use of a paste containing 3 to 50 parts by weight of at least one of zinc and zinc alloy relative to 100 parts by weight of aluminum, as in Samples 2 to 9 and 12 to 19. Furthermore, the warp was reduced by 0.5 mm or more by use of a paste containing 10 parts by weight or more of zinc or zinc alloy.

### EXAMPLE 2

Solar cell elements of Samples 3 to 5, 22 to 24, and 26 to 29 were subjected to a humidity test to evaluate the reduction rate of the FF value (fill factor). Although the humidity test is generally conducted under conditions at a temperature of 85°C and a humidity of 85% according to JIS C 8917, more severe conditions at a temperature of 90°C and a humidity of 95% were applied to the test in the present example. The evaluation in the present example was made according to relative values in percent obtained from "(FF after humidity test/FF value before humidity test)-100". The humidity test was conducted for 1000 hours, and FF values were measured after a lapse of 200 hours, 500 hours, and 840 hours.

**[Table 2]**

| Number | 200 hours | 500 hours | 840 hours | 1000 hours |
|---|---|---|---|---|
| 3 | - 3. 9% | - 2. 9% | - 4. 3% | - 4. 3% |
| 4 | - 3. 4% | - 1. 5% | - 2. 9% | - 2. 5% |
| 5 | - 2. 8% | - 0. 9% | - 2. 5% | - 1. 7% |
| 22 | -11. 5% | -12. 0% | -15. 0% | -15. 2% |
| 23 | -11. 4% | -12. 1% | -14. 8% | -15. 1% |
| 24 | -11. 6% | -12. 1% | -15. 1% | -15. 4% |
| 26 | -11. 3% | -11. 7% | -14. 5% | -14. 9% |
| 27 | -11. 4% | -11. 6% | -14. 3% | -14. 9% |
| 28 | -11. 3% | -11. 6% | -14. 3% | -14. 8% |
| 29 | -11. 0% | -11. 5% | -14. 2% | -14. 8% |

Table 2 shows that the reduction rate in FF value can be reduced by adding an inorganic particles containing Zn to a fired electrode mainly containing Al. Thus, it has been confirmed that the long-term reliability is enhanced.

### Brief Description of Drawings

[Fig. 1] Fig. 1 is a representation of a solar cell element according to an embodiment.
[Fig. 2] Figs. 2(a) and 2(b) are representations of the shape of the electrodes of the solar cell element shown in Fig. 1: (a) shows the electrodes on the light-reception surface (front surface); and (b) shows the electrodes on the non-light-reception surface (back surface).
[Fig. 3] Fig. 3 is a representation illustrating the evaluation method of the warp of the silicon substrate.
[Fig. 4] Fig. 4 is a cross-sectional view of a heating and drying apparatus.
[Fig. 5] Fig. 5 is a cross-sectional view of another heating and drying apparatus.
[Fig. 6] Fig. 6 is a cross-sectional view of still another heating and drying apparatus.

### Reference Numerals

- 1: silicon substrate
- 4: front surface electrode
- 5: back surface electrode
- 5a: current-collector portion (first electrode)
- 5b: power-extracting portion (second electrode)
- 6: back surface electric field region (BSF region)

## Claims

1. A solar cell element comprising:
a silicon substrate; and
a first electrode containing aluminum and a metal containing zinc, formed on the silicon substrate.

2. The solar cell element according to Claim 1, wherein the silicon substrate has a first surface receiving sunlight and a second surface opposite the first surface, and the first electrode is disposed on the second surface of the silicon substrate.

3. The solar cell element according to Claim 2, further comprising a second electrode on the second surface of the silicon substrate, the second electrode intersecting the first electrode.

4. The solar cell element according to Claim 1, wherein the metal containing zinc in the first electrode is joined to the aluminum.

5. The solar cell element according to Claim 1, wherein the metal of the first electrode is zinc.

6. The solar cell element according to Claim 5, wherein the zinc of the first electrode is contained in a proportion of 3 to 50 parts by weight to 100 parts by weight of the aluminum in the fired electrode.

7. The solar cell element according to Claim 1, wherein the metal is a zinc alloy.

8. The solar cell element according to Claim 7, wherein the zinc alloy of the first electrode is contained in a proportion of 3 to 50 parts by weight to 100 parts by weight of aluminum.

9. The solar cell element according to Claim 7, wherein the zinc alloy is a zinc-aluminum alloy.

10. The solar cell element according to Claim 1, wherein the first electrode further contains a glass frit.

11. A method for manufacturing a solar cell element, comprising:
the step of preparing a silicon substrate and an electroconductive paste containing aluminum and a metal containing zinc;
the step of applying the electroconductive paste onto the silicon substrate;
the step of heating the electroconductive paste applied onto the silicon substrate at a temperature higher than the melting point of the metal containing zinc to melt the electroconductive paste; and
the step of cooling the molten electroconductive paste to form an electrode.

12. The method for manufacturing a solar cell element according to Claim 11, wherein the molten metal containing zinc spread into the aluminum in the step of cooling the electroconductive paste.

13. The method for manufacturing a solar cell element according to Claim 11, wherein the molten metal containing zinc is joined to the aluminum in the step of cooling the electroconductive paste.

14. The method for manufacturing a solar cell element according to Claim 11, wherein the electroconductive paste is heated to 700 to 850°C.

15. The method for manufacturing a solar cell element according to Claim 11, wherein the electroconductive paste is cooled at a rate of 30°C/s or more.

16. The method for manufacturing a solar cell element according to Claim 11, further comprising the step of forming a rough surface at a surface of the silicon substrate.

17. The method for manufacturing a solar cell element according to Claim 16, further comprising the step of forming an antireflection coating on the rough surface of the silicon substrate.

18. The method for manufacturing a solar cell element according to Claim 16, wherein the rough surface is formed after the surface of the silicon substrate is cleaned.
